(19) **Europäisches Patentamt**
**European Patent Office**
**Office européen des brevets**

(11) **EP 3 411 910 B1**

(12) **FASCICULE DE BREVET EUROPEEN**

(45) Date de publication et mention
de la délivrance du brevet:
**01.09.2021 Bulletin 2021/35**

(51) Int Cl.:
*H01L 41/08* *(2006.01)* *H03H 9/00* *(2006.01)*
*H03H 9/02* *(2006.01)* *H01L 41/312* *(2013.01)*

(21) Numéro de dépôt: **17706273.4**

(22) Date de dépôt: **17.01.2017**

(86) Numéro de dépôt international:
**PCT/FR2017/050092**

(87) Numéro de publication internationale:
**WO 2017/134357 (10.08.2017 Gazette 2017/32)**

(54) **STRUCTURE HYBRIDE POUR DISPOSITIF A ONDES ACOUSTIQUES DE SURFACE**

HYBRIDSTRUKTUR FÜR EINE OBERFLÄCHENSCHALLWELLENVORRICHTUNG

HYBRID STRUCTURE FOR A SURFACE-ACOUSTIC-WAVE DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.02.2016 FR 1650774**

(43) Date de publication de la demande:
**12.12.2018 Bulletin 2018/50**

(73) Titulaire: **Soitec**
**38190 Bernin (FR)**

(72) Inventeurs:
• **KONONCHUK, Oleg**
**38570 Theys (FR)**
• **BUTAUD, Eric**
**38000 Grenoble (FR)**

• **DESBONNETS, Eric**
**38660 Lumbin (FR)**

(74) Mandataire: **IP Trust**
**2, rue de Clichy**
**75009 Paris (FR)**

(56) Documents cités:
**EP-A1- 2 658 122        EP-A2- 1 158 671**
**WO-A1-2005/036150    WO-A2-2009/019308**
**JP-A- 2001 196 896      US-A1- 2012 086 312**

• **T. Hanada: "Basic Properties of ZnO, GaN, and Related Materials" In: "Oxide and Nitride Semiconductors", 1 janvier 2009 (2009-01-01), Springer Berlin Heidelberg, Berlin, Heidelberg, XP055318503, ISSN: 1435-1889 ISBN: 978-3-540-88847-5 vol. 12, pages 1-19, DOI: 10.1007/978-3-540-88847-5_1, tableau 1.3**

EP 3 411 910 B1

**Description**

**DOMAINE DE L'INVENTION**

La présente invention concerne le domaine des dispositifs à ondes acoustiques de surface. Elle concerne en particulier une structure hybride adaptée pour la fabrication de dispositifs à ondes acoustiques de surface.

**ARRIERE PLAN TECHNOLOGIQUE DE L'INVENTION**

Les structures de résonateurs acoustiques tels que les dispositifs à ondes acoustiques de surface (« SAW » pour « Surface Acoustic Wave » selon la terminologie anglo-saxonne) utilisent un ou plusieurs transducteurs interdigités élaborés sur un substrat piézoélectrique pour convertir des signaux électriques en ondes acoustiques et vice versa. De tels dispositifs ou résonateurs SAW sont souvent utilisés dans les applications de filtrage. La technologie SAW à radiofréquences (RF) fournit d'excellentes performances telles qu'une haute isolation et de faibles pertes d'insertion. Pour cette raison, elle est utilisée pour les duplexeurs RF dans les applications de communication sans fil. Néanmoins, pour être plus concurrentielle par rapport aux duplexeurs RF basés sur la technologie des ondes acoustiques de volume (« BAW » pour « Bulk Acoustic Wave »), la performance des dispositifs SAW RF doit être améliorée et l'on exige en particulier que la réponse en fréquence soit stable vis-à-vis de la température.

La dépendance de la fréquence de fonctionnement des dispositifs SAW vis-à-vis de la température, ou le coefficient de fréquence thermique (« TCF » pour « Temperature Coefficient of Frequency »), dépend d'une part des variations de l'espacement entre les électrodes interdigitées des transducteurs, qui sont généralement dues aux coefficients de dilatation thermique (« CTE » pour « Coefficient of Thermal Expansion ») relativement élevés des substrats piézoélectriques utilisés ; d'autre part, le TCF dépend du coefficient de vitesse thermique car la dilatation ou la contraction du substrat piézoélectrique s'accompagne d'une augmentation ou d'une diminution de la vitesse de l'onde acoustique de surface. Pour minimiser le coefficient de fréquence thermique (TCF), un objectif est donc de minimiser la dilatation/contraction du substrat piézoélectrique, notamment dans la zone de surface dans laquelle les ondes acoustiques vont se propager.

L'article de K.Hashimoto, M.Kadota et al, « Recent development of temperature compensated SAW devices », IEEE Ultrason. Symp. 2011, pages 79 à 86, 2011, donne une vue d'ensemble des approches couramment utilisées pour surmonter le problème de dépendance vis-à-vis de la température de la réponse en fréquence des dispositifs SAW.

La première approche consiste à recouvrir la surface du substrat piézoélectrique comportant la structure métallique des transducteurs, d'une couche d'oxyde de silicium ($SiO_2$). Le CTE très faible du $SiO_2$ limite la dilatation/contraction du substrat piézoélectrique en température. Bien qu'améliorant les performances en température, cette approche présente des limitations : d'une part les contraintes de température pour le dépôt de cette couche d'oxyde (compte tenu de la présence de métaux) ne donnent accès qu'à des matériaux de relativement mauvaise qualité, ayant des performances acoustiques réduites ; d'autre part, avec cette approche, l'épaisseur finale du substrat piézoélectrique doit être supérieure à 200 microns pour garantir la tenue mécanique de la structure, ce qui limite les possibilités de packaging final du dispositif.

La seconde approche consiste à utiliser un substrat hybride, par exemple composé d'une couche de matériau piézoélectrique disposée sur un substrat de silicium. Là encore, le CTE faible du silicium permet de limiter la dilatation/contraction de la couche piézoélectrique en température. Dans le cas d'une couche piézoélectrique de Tantalate de Lithium (LiTa03), l'article précédemment cité indique qu'un ratio de 10 entre l'épaisseur de LiTaO3 et l'épaisseur du substrat de silicium permet d'améliorer convenablement le coefficient de fréquence thermique (TCF). L'un des inconvénients de cette approche vient de la présence d'ondes acoustiques parasites (appelées « spurious acoustic modes » dans l'article « Characterization of bonded wafer for RF filters with reduced TCF », B.P.Abbott et al, Proc 2005 IEEE International Ultrasonics Symposium, Sept 19-21, 2005, pp.926-929) qui impactent négativement les caractéristiques en fréquence du résonateur élaboré sur le substrat hybride. Ces résonances parasites sont notamment liées à des réflexions parasites de l'onde acoustique principale (se propageant principalement dans une zone superficielle de la couche de LiTaO3) sur les interfaces sous-jacentes, dont notamment l'interface entre le LiTaO3 et le silicium. Une solution pour diminuer ces résonances parasites est d'augmenter l'épaisseur de la couche de LiTaO3 ; cela supposant d'augmenter également l'épaisseur du substrat de Si pour conserver les améliorations du TCF, l'épaisseur totale du substrat hybride n'est plus compatible avec les besoins de réduction d'épaisseur des composants finaux, notamment pour adresser le marché des téléphones cellulaires. Une autre solution, proposée par K.Hashimoto et al. (Article précédemment cité) est de rugosifier la surface inférieure de la couche de LiTaO3 (à l'interface de collage avec le substrat) de façon à limiter les réflexions de l'onde acoustique sur celle-ci.

La demande de brevet US 2012/0086312 A1 propose une interface irrégulière pour supprimer les réflexions parasites des ondes acoustiques.

Les documents WO 2005/036150, EP 1 158 671 A et EP 2 658 122 A décrivent une structure périodique entre la couche utile et le substrat support perpendiculaire au plan de la couche utile et du substrat, cette structure périodique formant un réflecteur acoustique.

## OBJET DE L'INVENTION

Un objet de la présente invention est de proposer une solution alternative aux solutions de l'état de l'art. Un objet de l'invention est notamment de proposer une structure hybride permettant la réduction et/ou l'élimination desdites ondes acoustiques parasites.

## BREVE DESCRIPTION DE L'INVENTION

La présente invention concerne une structure hybride pour dispositif à ondes acoustiques de surface comprenant une couche utile de matériau piézoélectrique assemblée à un substrat support présentant un coefficient de dilatation thermique inférieur à celui de la couche utile ; la structure hybride est remarquable en ce qu'elle comprend une couche intermédiaire située entre la couche utile et le substrat support, la couche intermédiaire étant une couche structurée formée d'au moins deux matériaux différents et présentant une pluralité de motifs périodiques dans le plan de ladite couche intermédiaire.

Les dimensions latérales, la périodicité des motifs dans le plan de la couche intermédiaire et l'épaisseur de la couche intermédiaire sont définies en fonction de la fréquence de l'onde acoustique caractéristique du dispositif SAW afin de transmettre ou diffuser les ondes acoustiques habituellement réfléchies sur les interfaces de la structure hybride. La présence de la couche intermédiaire dans la structure hybride permet donc de diminuer drastiquement les réflexions parasites de l'onde acoustique qui impactent négativement les caractéristiques en fréquence du dispositif SAW.

Selon des caractéristiques avantageuses de l'invention, prises seules ou en combinaison :

- la périodicité des motifs est choisie en fonction de la fréquence des ondes acoustiques de surface du dispositif ;
- le substrat support comprend un matériau choisi parmi le silicium, le verre, la silice, le saphir, l'alumine, le nitrure d'aluminium ;
- la couche utile comprend un matériau piézoélectrique choisi parmi le tantalate de lithium (LiTaO3), le niobate de lithium (LiNbO3), le quartz, l'oxyde de zinc (ZnO) ;
- l'impédance acoustique moyenne de la couche intermédiaire est sensiblement égale à la racine carrée du produit des impédances acoustiques de la couche utile et du substrat support ;
- l'épaisseur de la couche intermédiaire est supérieure à la longueur d'onde des ondes acoustiques de surface du dispositif ;
- au moins une dimension latérale des motifs est inférieure à la longueur d'onde des ondes acoustiques de surface du dispositif ;
- les motifs périodiques comprennent une alternance d'un premier motif composé du matériau de la couche utile et d'un deuxième motif composé d'un matériau de même nature que celui du substrat support ;
- le deuxième motif est composé de silicium poly-cristallin et dans lequel le substrat support est en silicium ;
- l'épaisseur de la couche intermédiaire est égale ou sensiblement inférieure à la longueur d'onde des ondes acoustiques de surface du dispositif ;
- au moins une dimension latérale des motifs est inférieure ou égale à la longueur d'onde des ondes acoustiques de surface du dispositif ;
- les motifs périodiques comprennent une alternance d'un premier motif composé du matériau de la couche utile ou du matériau du substrat support et d'un deuxième motif composé d'un autre matériau ;
- le deuxième motif est composé de dioxyde de silicium, de nitrure de silicium ;

L'invention concerne également un procédé de fabrication d'une structure hybride pour un dispositif à ondes acoustiques de surface remarquable en ce qu'il comprend les étapes suivantes :

i) La fourniture d'une couche utile de matériau piézoélectrique et d'un substrat support présentant un coefficient de dilatation thermique inférieur à celui de la couche utile ;
ii) La gravure locale selon des motifs périodiques d'une face avant de la couche utile ou du substrat support, formant un ensemble de motifs gravés et de motifs non gravés d'un premier matériau ;
iii) Le dépôt sur les motifs gravés, d'une couche supplémentaire d'un deuxième matériau différent du premier matériau ; les motifs périodiques non gravés et la couche supplémentaire formant une couche intermédiaire ;
iv) L'assemblage de la couche utile et du substrat support, de sorte que la couche intermédiaire soit disposée entre la couche utile et le substrat support.

Selon des caractéristiques avantageuses de l'invention, prises seules ou en combinaison :

- la couche utile fournie à l'étape i) est un substrat donneur de matériau piézoélectrique ;
- le procédé comprend une étape v) d'amincissement du substrat donneur jusqu'à l'épaisseur souhaitée de la couche utile pour la fabrication du dispositif à ondes acoustiques.

## BREVE DESCRIPTION DES DESSINS

D'autres caractéristiques et avantages de l'invention ressortiront de la description détaillée qui va suivre en référence aux figures annexées sur lesquelles :

- la figure 1 présente une structure hybride conforme à l'invention ;
- la figure 2 présente une structure hybride conforme à l'invention comportant un dispositif SAW ;
- les figures 3a et 3b présentent une structure hybride selon un mode de réalisation conforme à l'invention ;
- les figures 4a à 4d présentent des exemples de motifs périodiques de la couche intermédiaire d'une structure hybride selon l'invention ;
- les figures 5a à 5c présentent des exemples de motifs vus en coupe de la couche intermédiaire d'une structure hybride selon l'invention.

## DESCRIPTION DETAILLEE DE L'INVENTION

Dans la partie descriptive, les mêmes références sur les figures pourront être utilisées pour des éléments de même nature. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

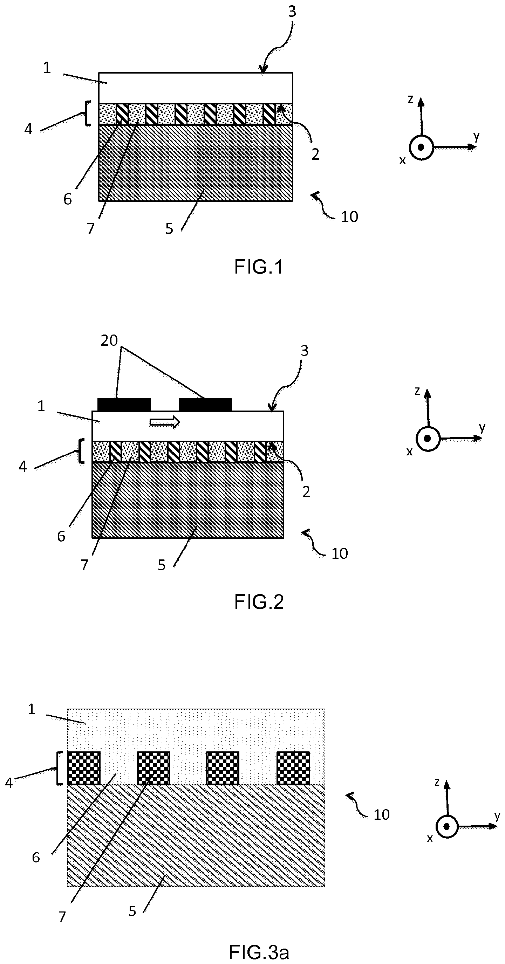

L'invention concerne une structure hybride 10 adaptée pour la fabrication d'un dispositif à ondes acoustiques de surface (SAW), comprenant une couche utile 1 de matériau piézoélectrique, présentant une première face 2 et une seconde face 3, comme illustré sur la figure 1. La structure hybride 10 inclut également une couche intermédiaire 4 disposée sous la couche utile (selon l'axe z représenté sur la figure 1), en contact avec la seconde face 2. La couche intermédiaire 4 est une couche structurée d'épaisseur e, formée par au moins deux matériaux différents. Par couche structurée, on entend une couche composée de motifs périodiques dans le plan de la couche (c'est-à-dire dans le plan (x,y) de la figure 1). Ces motifs correspondent à des blocs de dimensions latérales (ie les dimensions dans le plan (x,y)) définies et d'épaisseur (ie selon l'axe z) inférieure ou égale à e : ils sont constitués d'au moins deux matériaux différents. Selon l'exemple présenté sur la figure 1, la couche intermédiaire 4 est composée de premiers motifs 6 formés par un premier matériau et de deuxièmes motifs 7 (complémentaires des premiers motifs) formés par un deuxième matériau. Dans le plan (x,y), les premiers et deuxièmes motifs 6 et 7 présentent une forme (carré, rectangle, circulaire, ...) et des dimensions latérales définies.

Enfin, la structure hybride 10 comprend un substrat support 5 présentant un coefficient de dilatation thermique inférieur à celui de la couche utile 1, disposé sous la couche intermédiaire 4 (selon l'axe z représenté sur la figure 1). La couche utile 1 de la structure hybride 10 pourra être composée d'un matériau choisi dans le groupe : tantalate de lithium ($LiTaO_3$), niobate de lithium ($LiNbO_3$), nitrure d'aluminium (AlN), oxyde de zinc (ZnO). Le substrat support 5 pourra être composé d'un matériau choisi dans le groupe : silicium, semiconducteurs III-V, carbure de silicium, verre, saphir.

Comme illustré sur la figure 2, la structure hybride 10 est adaptée à la fabrication de dispositifs à ondes acoustiques de surface (SAW), comportant notamment des électrodes métalliques 20 sur la couche utile 1, entre lesquelles se propagent le signal acoustique. Le sens de propagation du signal acoustique est illustré par la flèche, dans la direction de l'axe y, dans l'exemple de la figure 2.

Selon un premier mode de réalisation de la structure hybride 10 de l'invention, la couche intermédiaire 4 est composée de deux matériaux : le premier matériau (composant les premiers motifs 6) est celui de la couche utile (matériau piézoélectrique) ; le deuxième matériau (composant les deuxièmes motifs 7) est de même nature que le substrat support de la structure hybride 10. L'épaisseur e de la couche intermédiaire 4 est supérieure à la longueur d'onde $\lambda$ du signal acoustique utilisé par le dispositif SAW, typiquement e pourra être comprise entre $2\lambda$ et $50\lambda$ ; cette caractéristique assure que l'onde acoustique qui se propagera dans la couche de matériau piézoélectrique voit la couche intermédiaire 4 et puisse subir son influence. Par ailleurs, au moins une dimension latérale (la dimension selon l'axe de propagation de l'onde acoustique dans le dispositif) des premiers et deuxièmes motifs périodiques, est inférieure à ladite longueur d'onde ; typiquement elle pourra être comprise entre $\lambda/2$ et $\lambda/50$. A l'échelle de l'onde acoustique, la couche intermédiaire apparaît ainsi comme un matériau composite, comprenant les premier et deuxième matériaux. Les dimensions latérales des motifs périodiques sont choisies de sorte que l'impédance acoustique moyenne de la couche intermédiaire 4 est sensiblement égale à la racine carrée du produit des impédances acoustiques de la couche utile 1 et du substrat support 5. Rappelons que l'impédance acoustique Z d'un matériau s'exprime comme :

$$Z = v.\rho = \sqrt{\frac{E}{3(1-2v)\rho}}.\rho = \sqrt{\frac{E.\rho}{3(1-2v)}}$$

où $v$ est la vitesse de l'onde acoustique dans le matériau, $\rho$ est la densité du matériau, E et v sont respectivement le module d'Young et le coefficient de Poisson du matériau.

Dans le cas de la couche intermédiaire 4, on considère les fractions volumiques $V_1$ et $V_2$ de chacun des matériaux la composant, on peut ainsi exprimer son impédance acoustique comme :

$$Z_{couche\ intermédiaire} = \sqrt{\left[\left(\frac{E_1.V_1}{3(1-2v_1)}\right) + \left(\frac{E_2.V_2}{3(1-2v_2)}\right)\right] \times [(\rho_1.V_1) + (\rho_2.V_2)]}$$

où $\rho_1$ et $\rho_2$ sont respectivement la densité du premier et du deuxième matériau, $E_1$ et $E_2$ sont respectivement le module d'Young du premier et du deuxième matériau et $v_1$ et $v_2$ le coefficient de Poisson du premier et du deuxième matériau.

Les fractions volumiques $V_1$ et $V_2$ sont définies par l'épaisseur e de la couche intermédiaire 4 et les dimensions latérales des premiers et deuxièmes motifs 6,7.

Les caractéristiques de la couche intermédiaire 4 (premier et deuxième matériau, dimensions latérales des motifs périodiques) sont ainsi définies de sorte que son impédance acoustique moyenne soit le plus proche possible de la racine carrée du produit des impédances acoustiques de la couche utile 1 et du substrat support 5 :

$$Z_{couche\ intermédiaire} \cong \sqrt{Z_{couche\ utile} \times Z_{substrat}}$$

Cette configuration permet de privilégier la transmission (par adaptation d'impédance acoustique) de la couche utile 1 vers le substrat 5, de la portion d'ondes acoustiques se réfléchissant habituellement aux interfaces d'une structure hybride : elle permet donc de diminuer drastiquement les réflexions parasites impactant négativement les caractéristiques en fréquence du dispositif SAW élaboré sur la structure hybride 10.

Selon un deuxième mode de réalisation de la structure hybride 10 conforme à l'invention, la couche intermédiaire 4 est également composée de deux matériaux (figure 3a) mais présente des caractéristiques physiques différentes du premier mode de réalisation. D'une part, l'épaisseur e de la couche intermédiaire est égale ou sensiblement inférieure à la longueur d'onde $\lambda$ du signal acoustique utilisé pour le dispositif SAW, par exemple comprise entre $\lambda$ et $\lambda/8$. D'autre part, au moins une dimension latérale (celle selon l'axe de propagation de l'onde acoustique dans le dispositif) des motifs périodiques est inférieure ou égale à la longueur d'onde $\lambda$ de l'onde acoustique ; typiquement elle pourra être comprise entre $\lambda/10$ et $\lambda$. Cette configuration favorise l'interaction entre l'onde acoustique et la couche intermédiaire 4. En particulier, la portion d'onde acoustique se réfléchissant habituellement aux interfaces de la structure hybride sera avantageusement diffusée par la couche intermédiaire 4 : cela aura pour résultat de limiter fortement la composante réfléchie de l'onde acoustique à l'origine des effets parasites.

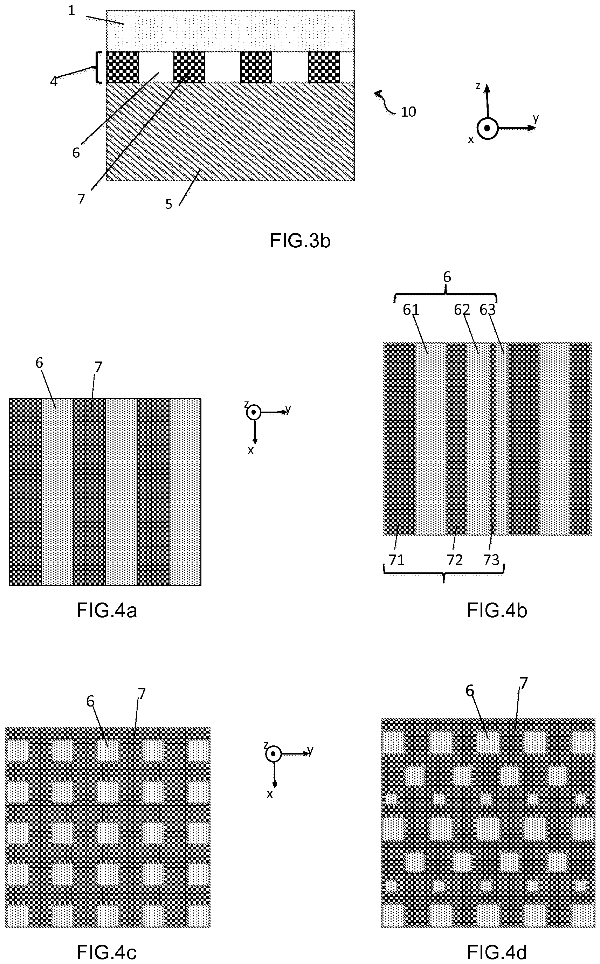

Selon une variante du deuxième mode de réalisation de l'invention, la couche intermédiaire peut être composée d'air ou de gaz (au niveau des premiers motifs 6 formant des cavités) et d'un deuxième matériau (au niveau des deuxièmes motifs 7) (figure 3b) ; par exemple, les deuxièmes motifs 7 pourront être formés du même matériau que le substrat support 5. Avantageusement, les matériaux constituant respectivement les premiers et deuxièmes motifs seront choisis de manière à générer un contraste acoustique entre les premiers motifs et les deuxièmes motifs.

Les dimensions latérales des premiers et deuxièmes motifs (et donc la périodicité desdits motifs) sont définies en fonction de la fréquence de l'onde acoustique caractéristique du dispositif SAW, ainsi que l'épaisseur de la couche intermédiaire 4, et ce afin de transmettre ou diffuser les ondes acoustiques habituellement réfléchies sur les interfaces de la structure hybride.

Les figures 4a à 4d présentent des variantes de disposition des motifs périodiques 6,7 de la couche intermédiaire 4. Dans l'exemple de la figure 4a, montrant la couche intermédiaire 4 en vue de dessus, dans le plan (x,y) les premiers motifs 6 et les deuxièmes motifs 7 ont une forme de bande. Rappelons que dans ce cas, le dispositif SAW doit être élaboré de sorte que la propagation des ondes acoustiques se fasse parallèlement à l'axe y, soit perpendiculairement auxdites bandes. Les dimensions latérales selon l'axe y (largeur des bandes) des premiers et deuxièmes motifs seront choisies selon les modes de réalisation (inférieure ou sensiblement égale à la longueur d'onde de l'onde acoustique).

Selon une variante en figure 4b, la dimension de plusieurs premiers motifs 6 consécutifs est différente : par exemple on observe une alternance de premiers motifs 6 avec des bandes 61, 62, 63 de largeurs différentes selon l'axe y. Une alternance similaire peut également être faite sur les deuxièmes motifs 7 avec des bandes 71, 72, 73 de largeurs différentes. Cette alternance est périodiquement répétée sur toute la surface de la couche intermédiaire 4. Une telle configuration est particulièrement favorable dans le deuxième mode de réalisation de l'invention pour diffuser les ondes acoustiques sur une gamme de fréquences plus étendue.

Selon une autre variante illustrée en figure 4c, les premiers motifs sont des pavés, par exemple de forme carrée, dont les dimensions selon l'axe x et l'axe y sont définies selon les critères des premier ou deuxième modes de réalisation de l'invention. Les deuxièmes motifs sont les motifs complémentaires des premiers motifs dans le plan (x,y). Une telle disposition de motifs rend la structure hybride 10 indépendante de l'orientation des dispositifs et de la direction de propagation des ondes acoustiques. Selon une autre variante en figure 4d, les premiers motifs sont des carrés de dimensions différentes, répétés périodiquement. Une telle configuration est intéressante dans le deuxième mode de réalisation de l'invention pour diffuser les ondes acoustiques sur une gamme de fréquences plus étendue.

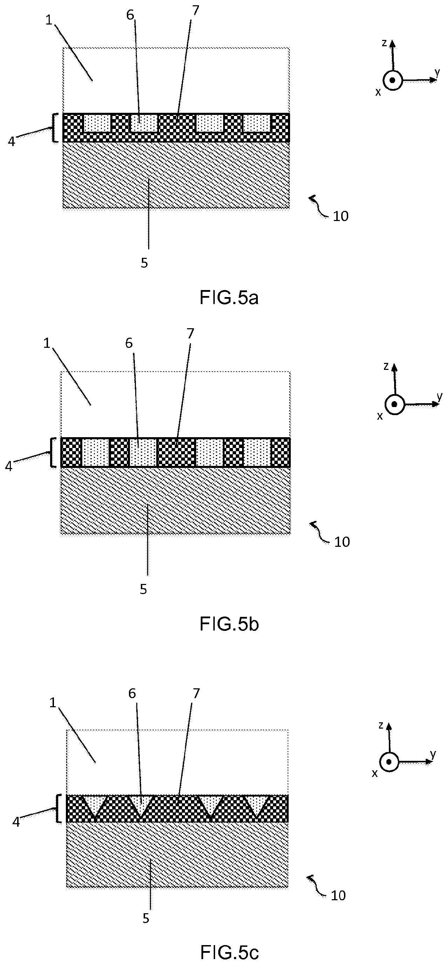

Les figures 5a à 5c présente des vues en coupe de structures hybrides selon l'invention. Les motifs périodiques 6,7 de la couche intermédiaire 4 peuvent avoir différentes formes selon l'axe z. Selon une variante, ils forment des créneaux (figure 5a et 5b) ; les premiers motifs 6 ont une dimensions selon z inférieure ou égale à l'épaisseur de la couche intermédiaire 4. Selon une autre variante (figure 5c), ils forment des motifs en V, pouvant permettre d'optimiser la diffusion des ondes parasites par orientation des plans de réflexion entre les motifs dans la couche intermédiaire 4.

Les exemples cités ne sont bien entendu pas exhaustifs et les motifs pourront avoir des formes diverses, dans le plan (x,y) ou dans un plan perpendiculaire sans sortir du cadre de l'invention.

Selon une variante applicable au premier ou au deuxième mode de réalisation de la structure hybride 10, la couche intermédiaire peut être formée de trois ou plus matériaux différents.

L'invention concerne également un procédé de fabrication d'une structure hybride 10 pour un dispositif à ondes acoustiques de surface. Le procédé comprend une première étape de fourniture d'une couche utile 1 de matériau piézoélectrique. Selon un mode de mise en œuvre avantageux, la couche utile se présente sous la forme d'un substrat de matériau piézoélectrique, d'épaisseur et de diamètre standard pour l'industrie micro-électronique (par exemple 150mm de diamètre et 675 $\mu$m d'épaisseur).

La première étape comporte également la fourniture d'un substrat support 5 présentant un coefficient de dilatation thermique inférieur à celui du substrat donneur (soit également celui de la couche utile 1).

Le procédé de fabrication selon l'invention comprend une deuxième étape consistant en une gravure locale selon des motifs périodiques d'une face avant du substrat donneur, formant ainsi un ensemble de motifs gravés et de motifs non gravés. En référence à la structure hybride décrite précédemment, les motifs gravés pourront être indifféremment les premiers ou les deuxièmes motifs (la même remarque s'applique aux motifs non gravés). Cette étape de gravure pourra par exemple être réalisée par attaque chimique sèche ou humide, par gravure laser ou autre technique adaptée à la gravure locale de motifs micrométriques. Préalablement à l'étape de gravure, une étape de photolithographie pourra être réalisée pour définir les zones à graver.

De manière alternative, la deuxième étape de gravure peut être réalisée non pas sur le substrat donneur mais sur une face avant du substrat support.

Le procédé de fabrication comprend une troisième étape de dépôt, sur les motifs gravés, d'une couche supplémentaire d'un deuxième matériau différent du premier matériau constituant les motifs non gravés. Cette couche supplémentaire pourra être formée par exemple par dépôt chimique en phase vapeur, en phase liquide, ou par épitaxie, etc.

Les motifs périodiques non gravés et la couche supplémentaire forment la couche intermédiaire 4 de la structure hybride 10 selon l'invention. Avantageusement, la profondeur de gravure (définissant la hauteur, selon l'axe z, des motifs non gravés) définit l'épaisseur e de la couche intermédiaire 4. La couche supplémentaire pourra avantageusement subir un traitement de planarisation ou de lissage de surface préalablement à l'étape suivante d'assemblage.

Le procédé comprend une quatrième étape d'assemblage du substrat donneur et du substrat support 5, de sorte que la couche intermédiaire 4 soit disposée entre ces deux substrats. Avantageusement, cette étape d'assemblage est réalisée par collage direct, par adhésion moléculaire des deux surfaces mises en contact (c'est-à-dire la surface de la couche intermédiaire 4 et la surface du substrat ne comportant pas la couche intermédiaire). Le principe de l'adhésion moléculaire, bien connu dans l'état de l'art ne sera pas décrit plus en détail. De manière alternative, l'assemblage pourra être réalisé par ajout d'une couche de matière adhésive, ou par toute autre technique de collage adaptée à l'application visée.

Le procédé de fabrication selon l'invention peut comprendre en outre une cinquième étape d'amincissement du substrat donneur jusqu'à l'épaisseur souhaitée de la couche utile 1 pour la fabrication du dispositif à ondes acoustiques. Cette étape pourra par exemple consister en un rodage mécanique (« grinding ») suivi d'un polissage à sec ou mécano-chimique, permettant d'assurer un bon état de surface à la couche utile 1. Bien sur, différentes séquences de nettoyage pourront être appliquées pendant ou après l'étape d'amincissement pour garantir la qualité et la propreté de la structure hybride finale 10.

Exemple 1 :

Dans un exemple de mise en œuvre de l'invention, un substrat donneur en niobate de lithium (LiNbO3) et un substrat support en silicium 5, tous deux d'un diamètre de 150mm et d'une épaisseur de 675 $\mu$m sont fournis. La résistivité du substrat support sera par exemple choisie > 1000 ohms.cm. Le substrat donneur LiNb03 est soumis à une étape de photolithographie pour définir des motifs : les premiers motifs 6 sont définis comme les zones qui ne seront pas gravées ; les deuxièmes motifs 7 sont définis comme les zones qui seront gravées. Les premiers motifs correspondent à des pavés carrés de 0,3 $\mu$m de côté, espacés entre eux de 0,2 $\mu$m. Les deuxièmes motifs correspondent à un quadrillage entre les pavés, dont la largeur des bandes est de 0,2 $\mu$m, soit la zone complémentaire auxdits pavés à la surface du substrat donneur. L'étape de gravure de la surface du substrat donneur est effectuée par gravure sèche, sur une profondeur de 5 $\mu$m. Après retrait du masque de photolithographie à la surface du substrat donneur et nettoyage de celui-ci (par exemple par une séquence RCA, classiquement utilisée dans l'industrie micro-électronique), une couche supplémentaire de silicium poly-cristallin est déposée par exemple par CVD (« Chemical vapor déposition »). Afin de remplir les zones gravées (deuxièmes motifs), on pourra déposer une épaisseur comprise entre 6 et 12 $\mu$m, avantageusement 8 $\mu$m. On opère ensuite une étape de planarisation par polissage mécano-chimique, pour résorber les éventuelles topologies et rugosités résiduelles après le dépôt de p-Si.

La couche intermédiaire 4 est constituée des premiers motifs 6 en matériau piézoélectrique et de la couche supplémentaire (p-Si) remplissant les deuxièmes motifs 7. Selon une première variante, l'épaisseur de la couche intermédiaire 4 correspond à la profondeur de gravure, soit 5 $\mu$m dans cet exemple ; dans ce cas, l'étape de planarisation aura permis de retirer le silicium poly-cristallin de la surface du substrat donneur jusqu'à affleurer les premiers motifs (configuration illustrée sur la figure 5b). Selon une deuxième variante, l'épaisseur e de la couche intermédiaire 4 est supérieure à la profondeur de gravure car il reste une épaisseur de la couche supplémentaire sur les premiers motifs (configuration illustrée sur la figure 5a, la couche supplémentaire se trouve entre et sous les premiers motifs 6 dans la structure hybride finale 10 représentée sur ladite figure). A titre d'exemple, la couche supplémentaire au dessus des premiers motifs pourra être de 1 $\mu$m : la couche intermédiaire aura ainsi une épaisseur de 6 $\mu$m.

Une fois la surface du substrat donneur préparée, l'étape d'assemblage avec le substrat support 5 est effectuée. Une séquence de nettoyage des deux substrats pourra être opérée préalablement à l'assemblage, en particulier dans le cas d'un collage direct par adhésion moléculaire, qui est particulièrement sensible à la présence de contaminations ou de particules sur les surfaces à assembler. Pour augmenter les forces d'adhésion entre les substrats, leurs surfaces pourront être traitées par plasma oxygène ou azote préalablement à la mise en contact.

Après collage, un recuit de consolidation à basse température est effectué, habituellement dans la gamme de 80-120°C, compte tenu de la différence importante de dilatation thermique entre les matériaux des substrats assemblés.

Une étape d'amincissement mécanique suivie d'une étape de polissage mécano-chimique de la face arrière du substrat donneur est opérée pour obtenir la couche utile de la structure hybride, d'une épaisseur de 20 $\mu$m.

La structure hybride obtenue est ainsi composée d'une couche utile de LiNbO3 de 20 $\mu$m, d'une couche intermédiaire d'une épaisseur comprise entre 5 et 6 $\mu$m (selon les variantes précédemment citées) et composée de deux matériaux : des premiers motifs en LiNbO3 et des deuxièmes motifs en poly-silicium. La taille des premiers motifs dans le plan (x, y) est de 0,3 $\mu$m et leur espacement est de 0,2 $\mu$m. L'impédance acoustique moyenne de cette couche est donc d'environ 1.5e6 g/cm$^2$/sec, soit une valeur très proche de la racine carrée du produit des impédances du LiNbO3 et du silicium.

Cette structure hybride est destinée à la fabrication d'un dispositif à ondes acoustiques de surface dont la longueur d'onde $\lambda$ est de l'ordre de 2 $\mu$m. Compte tenu de la faible épaisseur de la couche utile, une partie des ondes acoustiques pénètre dans la couche et se propage jusqu'à la couche intermédiaire. Habituellement, ces ondes sont réfléchies sur les interfaces (LiNbO3/Si par exemple) et génèrent des ondes parasites dégradant la performance du dispositif.

La configuration de la couche intermédiaire 4 de la structure hybride 10 selon l'invention permet de favoriser la transmission vers le substrat support 5 de silicium des ondes acoustiques pénétrant dans la profondeur de la couche utile 1. L'impédance acoustique moyenne de la couche intermédiaire 4 est correctement adaptée aux matériaux environnants (LiNbO3 et Si). L'épaisseur e de la couche intermédiaire 4 est supérieure à la longueur d'onde de l'onde acoustique du dispositif ; la taille et l'espacement des premiers motifs sont inférieurs à la longueur d'onde.

Par ailleurs, la structure hybride 10 décrite ici présente un avantage significatif concernant les performances RF du dispositif. En effet, la couche supplémentaire de poly-silicium constitue une couche de piégeage pour les charges générées dans le substrat support 5 de silicium lorsqu'il est soumis à des signaux haute fréquence. Ces charges sont connues pour faire chuter la résistivité du substrat support 5, ce qui impacte négativement les performances de linéarité et de perte d'insertion du dispositif RF. La couche supplémentaire de p-Si joue ainsi un rôle additionnel de couche de piégeage et neutralise les charges générées dans le substrat support 5.

Exemple 2 :

Dans un autre exemple de mise en œuvre de l'invention, un substrat donneur en tantalate de lithium (LiTaO3) et un substrat support en silicium, tous deux d'un diamètre de 150mm et d'une épaisseur de 675 $\mu$m sont fournis. La résistivité du substrat support sera par exemple choisie > 1000 ohms.cm. Le substrat donneur LiTa03 est soumis à une étape de photolithographie pour définir des motifs (dans le plan (x,y) : les premiers motifs 6 sont définis comme les zones qui ne seront pas gravées ; les deuxièmes motifs 7 sont définis comme les zones qui seront gravées. Les premiers motifs 6 correspondent à des bandes de 1,25 $\mu$m de largeur, espacés entre elles de 1,25 $\mu$m. Les deuxièmes motifs 7 correspondent à des bandes complémentaires des bandes des premiers motifs 6, à la surface du substrat donneur. L'étape de gravure de la surface du substrat donneur est effectuée par gravure sèche, sur une profondeur d'environ 1,5 $\mu$m. Après retrait du masque de photolithographie à la surface du substrat donneur et nettoyage de celui-ci une couche supplémentaire d'oxyde silicium est déposée par exemple par CVD (« Chemical vapor deposition »). Afin de remplir les zones gravées (deuxièmes motifs), on déposera une épaisseur comprise entre 2 et 6 $\mu$m, avantageusement 4 $\mu$m. On opère ensuite une étape de planarisation par polissage mécano-chimique de la couche supplémentaire, pour résorber les éventuelles topologies et rugosités résiduelles après le dépôt d'oxyde.

La couche intermédiaire 4 est constituée des premiers motifs 6 en matériau piézoélectrique (LiTaO3) et de la couche supplémentaire (SiO2) remplissant les deuxièmes motifs 7. Selon une première variante, l'épaisseur de la couche intermédiaire 4 correspond à la profondeur de gravure, soit 1,5 $\mu$m dans cet exemple ; dans ce cas, l'étape de planarisation aura permis de retirer l'oxyde de silicium de la surface du substrat donneur jusqu'à affleurer les premiers motifs 6. Selon une deuxième variante, l'épaisseur de la couche intermédiaire 4 est supérieure à la profondeur de gravure car il reste une épaisseur de la couche supplémentaire sur les premiers motifs 6. Par exemple, la couche supplémentaire au dessus des premiers motifs 6 pourra être de 0,5 $\mu$m : la couche intermédiaire 4 aura ainsi une épaisseur de 2 $\mu$m.

Une fois la surface du substrat donneur préparée, l'étape d'assemblage avec le substrat support est effectuée. Une séquence de nettoyage des deux substrats pourra être opérée préalablement à l'assemblage, en particulier dans le cas d'un collage direct par adhésion moléculaire, qui est particulièrement sensible à la présence de contaminations ou de particules sur les surfaces à assembler. Pour augmenter les forces d'adhésion entre les substrats, leurs surfaces pourront être traitées par plasma oxygène ou azote préalablement à la mise en contact.

Après collage, un recuit de consolidation à basse température est effectué, habituellement dans la gamme de 80-120°C, compte tenu de la différence importante de dilatation thermique entre les matériaux des substrats assemblés.

Une étape d'amincissement mécanique suivie d'une étape de polissage mécano-chimique de la face arrière du substrat donneur est opérée pour obtenir la couche utile de la structure hybride, d'une épaisseur de 30 $\mu$m.

La structure hybride obtenue est ainsi composée d'une couche utile de LiTaO3 de 30 $\mu$m, d'une couche intermédiaire d'une épaisseur comprise entre 1,5 et 2 $\mu$m (selon les variantes précédemment citées) et composée de deux matériaux : des premiers motifs en LiTaO3 et des deuxièmes motifs en oxyde de silicium. La taille des premiers motifs selon l'axe y est de 1,25 $\mu$m et leur espacement est de 1,25 $\mu$m.

Cette structure hybride 10 est destinée à la fabrication d'un dispositif à ondes acoustiques de surface dont la fréquence est dans la gamme 700-900 MHz, soit une longueur d'onde de l'ordre de 5 $\mu$m. La propagation des ondes acoustiques se fera selon l'axe y. Compte tenu de la faible épaisseur de la couche utile, une partie des ondes acoustiques pénètre dans la couche utile 1 et se propage jusqu'à la couche intermédiaire 4. Habituellement, ces ondes sont réfléchies sur les interfaces (LiTaO3/Si par exemple) et génèrent des ondes parasites dégradant la performance du dispositif.

La configuration de la couche intermédiaire 4 de la structure hybride 10 selon l'invention permet de favoriser la diffusion sur la couche intermédiaire 4 des ondes acoustiques pénétrant dans la couche utile 1, et donc de limiter leur réflexion. L'épaisseur e de la couche intermédiaire 4 est sensiblement inférieure à la longueur d'onde de l'onde acoustique du dispositif ; la taille et l'espacement des premiers motifs sont inférieurs à la longueur d'onde.

Exemple 3 :

Dans un autre exemple de mise en œuvre de l'invention, un substrat donneur en tantalate de lithium (LiTaO3) et un substrat support en silicium, tout deux d'un diamètre de 150mm et d'une épaisseur de 625 $\mu$m sont fournis. La résistivité du substrat support sera par exemple choisie > 1000 ohms.cm. Le substrat support est soumis à une étape de photolithographie pour définir des motifs : les premiers motifs 6 sont définis comme les zones qui ne seront pas gravées ; les deuxièmes motifs 7 sont définis comme les zones qui seront gravées. Les premiers motifs 6 correspondent à des bandes de 1,25 $\mu$m de largeur, espacés entre elles de 1,25 $\mu$m. Les deuxièmes motifs correspondent à des bandes complémentaires des bandes des premiers motifs, à la surface du substrat support. L'étape de gravure de la surface du substrat support est effectuée par gravure sèche, sur une profondeur de 1 micron. Après retrait du masque de photolithographie à la surface, le substrat support est nettoyé en vue de l'étape d'assemblage avec le substrat donneur. Dans ce troisième exemple, il n'y a pas de couche supplémentaire déposée. Le premier matériau (constituant les premiers motifs) est du silicium et le deuxième matériau est de l'air ou un gaz selon l'atmosphère introduite pendant l'étape d'assemblage dans la chambre de collage.

Après collage, un recuit de consolidation à basse température est effectué, habituellement dans la gamme de 80-120°C, compte tenu de la différence importante de dilatation thermique entre les matériaux des substrats assemblés.

Une étape d'amincissement mécanique suivie d'une étape de polissage mécano-chimique de la face arrière du substrat donneur est opérée pour obtenir la couche utile de la structure hybride, d'une épaisseur de 20 μm.

La structure hybride obtenue est ainsi composée d'une couche utile de LiTaO3 de 20 μm, d'une couche intermédiaire d'une épaisseur 1 μm et composée de deux matériaux : des premiers motifs en silicium et des deuxièmes motifs rempli d'air ou de gaz. La taille des premiers motifs selon l'axe y est de 1,25 μm et leur espacement est de 1,25 μm.

Cette structure hybride est destinée à la fabrication d'un dispositif à ondes acoustiques de surface dont la fréquence est de 700-900 MHz, soit une longueur d'onde de l'ordre de 5 μm. Compte tenu de la faible épaisseur de la couche utile, une partie des ondes acoustiques pénètre dans la couche et se propage jusqu'à la couche intermédiaire 4. Habituellement, ces ondes sont réfléchies sur les interfaces (LiTaO3/Si par exemple) et génèrent des ondes parasites dégradant la performance du dispositif.

La configuration de la couche intermédiaire 4 de la structure hybride 10 selon l'invention permet de favoriser la diffusion sur la couche intermédiaire 4 des ondes acoustiques pénétrant dans la couche utile 1, et donc de limiter leur réflexion. L'épaisseur e de la couche intermédiaire 4 est sensiblement inférieure à la longueur d'onde de l'onde acoustique du dispositif ; la taille et l'espacement des premiers motifs sont inférieurs à la longueur d'onde.

Bien entendu, l'invention n'est pas limitée aux modes de mise en œuvre et exemples décrits, et on peut y apporter des variantes de réalisation sans sortir du cadre de l'invention tel que défini par les revendications.

La structure hybride 10 selon l'invention peut notamment être adaptée à la fabrication de dispositifs à ondes acoustiques de surface dont la fréquence est comprise dans la gamme de 700 MHz - 3 GHz.

**Revendications**

1. Structure hybride (10) pour dispositif à ondes acoustiques de surface comprenant une couche utile (1) de matériau piézoélectrique assemblée à un substrat support (5) présentant un coefficient de dilatation thermique inférieur à celui de la couche utile (1), et comprenant une couche intermédiaire (4) située entre la couche utile (1) et le substrat support (5), **caractérisée en ce que** la couche intermédiaire (4) est une couche structurée formée d'au moins deux matériaux différents et présente une pluralité de motifs périodiques (6,7) dans le plan de ladite couche intermédiaire (4) .

2. Structure hybride (10) pour dispositif à ondes acoustiques de surface selon la revendication précédente, dans laquelle la périodicité des motifs (6,7) est choisie en fonction de la fréquence des ondes acoustiques de surface du dispositif.

3. Structure hybride (10) pour dispositif à ondes acoustiques de surface selon l'une des revendications précédentes, dans laquelle le substrat support (5) comprend un matériau choisi parmi le silicium, le verre, la silice, le saphir, l'alumine, le nitrure d'aluminium.

4. Structure hybride (10) pour dispositif à ondes acoustiques de surface selon l'une des revendications précédentes, dans laquelle la couche utile (1) comprend un matériau piézoélectrique choisi parmi le tantalate de lithium (LiTaO3), le niobate de lithium (LiNbO3), le quartz, l'oxyde de zinc (ZnO).

5. Structure hybride (10) pour dispositif à ondes acoustiques de surface selon l'une des revendications précédentes, dans laquelle l'impédance acoustique moyenne de la couche intermédiaire (4) est égale à la racine carrée du produit des impédances acoustiques de la couche utile (1) et du substrat support (5).

6. Structure hybride (10) pour dispositif à ondes acoustiques de surface selon l'une des revendications précédentes, dans laquelle l'épaisseur de la couche intermédiaire (4) est supérieure à la longueur d'onde des ondes acoustiques de surface du dispositif.

7. Structure hybride (10) pour dispositif à ondes acoustiques de surface selon l'une des revendications précédentes, dans laquelle au moins une dimension latérale des motifs (6,7) est inférieure à la longueur d'onde des ondes acoustiques de surface du dispositif.

8. Structure hybride (10) pour dispositif à ondes acoustiques de surface selon l'une des revendications précédentes, dans laquelle les motifs périodiques (6,7) comprennent une alternance d'un premier motif (6) composé du matériau de la couche utile (1) et d'un deuxième motif (7) composé d'un matériau de même nature que celui du substrat support (5).

9. Structure hybride (10) pour dispositif à ondes acoustiques de surface selon la revendication précédente, dans laquelle le deuxième motif (7) est composé de silicium poly-cristallin et dans lequel le substrat support (5) est en silicium.

10. Structure hybride (10) pour dispositif à ondes acoustiques de surface selon l'une des revendications 1 à 4, dans laquelle l'épaisseur de la couche intermédiaire (4) est égale ou inférieure à la longueur d'onde des ondes acoustiques de surface du dispositif.

11. Structure hybride (10) pour dispositif à ondes acoustiques de surface selon la revendication précédente, dans laquelle au moins une dimension latérale des motifs (6,7) est inférieure ou égale à la longueur d'onde des ondes acoustiques de surface du dispositif.

12. Structure hybride (10) pour dispositif à ondes acoustiques de surface selon l'une des deux revendications précédentes, dans laquelle les motifs périodiques (6,7) comprennent une alternance d'un premier motif (6) composé du matériau de la couche utile (1) ou du matériau du substrat support et d'un deuxième motif (7) composé d'un autre matériau.

13. Structure hybride (10) pour dispositif à ondes acoustiques de surface selon la revendication précédente, dans laquelle le deuxième motif (7) est composé de dioxyde de silicium ou de nitrure de silicium.

14. Procédé de fabrication d'une structure hybride (10) pour un dispositif à ondes acoustiques de surface **caractérisé en ce qu'**il comprend les étapes suivantes :

i) La fourniture d'une couche utile (1) de matériau piézoélectrique et d'un substrat support (5) présentant un coefficient de dilatation thermique inférieur à celui de la couche utile (1) ;
ii) La gravure locale selon des motifs périodiques d'une face avant de la couche utile (1) ou du substrat support (5), formant un ensemble de motifs gravés et de motifs non gravés d'un premier matériau ;
iii) Le dépôt sur les motifs gravés, d'une couche supplémentaire d'un deuxième matériau différent du premier matériau ; les motifs périodiques non gravés et la couche supplémentaire formant une couche intermédiaire (4) ;
iv) L'assemblage de la couche utile (1) et du substrat support (5), de sorte que la couche intermédiaire (4) soit disposée entre la couche utile (1) et le substrat support (5).

15. Procédé de fabrication d'une structure hybride (10) pour un dispositif à ondes acoustiques de surface selon la revendication précédente, dans lequel la couche utile (1) fournie à l'étape i) est un substrat donneur de matériau piézoélectrique.

16. Procédé de fabrication d'une structure hybride (10) pour un dispositif à ondes acoustiques de surface selon la revendication précédente, comprenant une étape v) d'amincissement du substrat donneur jusqu'à l'épaisseur souhaitée de la couche utile (1) pour la fabrication du dispositif à ondes acoustiques.

**Patentansprüche**

1. Hybridstruktur (10) für eine Oberflächenschallwellenvorrichtung, die eine Nutzschicht (1) aus piezoelektrischem Material umfasst, die auf einem Trägersubstrat (5) mit einem geringeren Wärmeausdehnungskoeffizienten als dem der Nutzschicht (1) aufgebacht ist, und eine zwischen der Nutzschicht (1) und dem Trägersubstrat (5) liegende Zwischenschicht (4) umfasst, **dadurch gekennzeichnet, dass** die Zwischenschicht (4) eine aus mindestens zwei unterschiedlichen Materialien gebildete strukturierte Schicht ist und in der Ebene der Zwischenschicht (4) mehrere periodische Muster (6, 7) aufweist.

2. Hybridstruktur (10) für eine Oberflächenschallwellenvorrichtung nach dem vorhergehenden Anspruch, wobei die Periodizität der Muster (6, 7) in Abhängigkeit von der Frequenz der Oberflächenschallwellen der Vorrichtung gewählt wird.

3. Hybridstruktur (10) für eine Oberflächenschallwellenvorrichtung nach einem der vorhergehenden Ansprüche, wobei das Trägersubstrat (5) ein Material umfasst, das aus Silizium, Glas, Siliziumdioxid, Saphir, Aluminiumoxid und Aluminiumnitrid ausgewählt ist.

4. Hybridstruktur (10) für eine Oberflächenschallwellenvorrichtung nach einem der vorhergehenden Ansprüche, wobei die Nutzschicht (1) ein piezoelektrisches Material umfasst, das aus Lithiumtantalat (LiTaO3), Lithiumniobat (LiNbO3), Quarz und Zinkoxid (ZnO) ausgewählt ist.

5. Hybridstruktur (10) für eine Oberflächenschallwellenvorrichtung nach einem der vorhergehenden Ansprüche, wobei die mittlere akustische Impedanz der Zwischenschicht (4) gleich der Quadratwurzel des Produkts aus den akustischen Impedanzen der Nutzschicht (1) und des Trägersubstrats (5) ist.

6. Hybridstruktur (10) für eine Oberflächenschallwellenvorrichtung nach einem der vorhergehenden Ansprüche, wobei die Dicke der Zwischenschicht (4) größer als die Wellenlänge der Oberflächenschallwellen der Vorrichtung ist.

7. Hybridstruktur (10) für eine Oberflächenschallwellenvorrichtung nach einem der vorhergehenden Ansprüche, wobei mindestens eine seitliche Abmessung der Muster (6, 7) kleiner als die Wellenlänge der Oberflächenschallwellen der Vorrichtung ist.

8. Hybridstruktur (10) für eine Oberflächenschallwellenvorrichtung nach einem der vorhergehenden Ansprüche, wobei die periodischen Muster (6, 7) einen Wechsel eines ersten Musters (6), das aus dem Material der Nutzschicht (1) besteht, und eines zweiten Musters (7), das aus einem Material der gleichen Beschaffenheit wie das des Trägersubstrats (5) besteht, umfassen.

9. Hybridstruktur (10) für eine Oberflächenschallwellenvorrichtung nach dem vorhergehenden Anspruch, wobei das zweite Muster (7) aus polykristallinem Silizium besteht und wobei das Trägersubstrat (5) aus Silizium besteht.

10. Hybridstruktur (10) für eine Oberflächenschallwellenvorrichtung nach einem der Ansprüche 1 bis 4, wobei die Dicke der Zwischenschicht (4) gleich oder kleiner als die Wellenlänge der Oberflächenschallwellen der Vorrichtung ist.

11. Hybridstruktur (10) für eine Oberflächenschallwellenvorrichtung nach dem vorhergehenden Anspruch, wobei mindestens eine seitliche Abmessung der Muster (6, 7) kleiner oder gleich der Wellenlänge der akustischen Oberflächenwellen der Vorrichtung ist.

12. Hybridstruktur (10) für eine Oberflächenschallwellenvorrichtung nach einem der beiden vorhergehenden Ansprüche, wobei die periodischen Muster (6, 7) einen Wechsel eines ersten Musters (6), das aus dem Material der Nutzschicht (1) oder dem Material der Trägersubstrat besteht, und eines zweiten Musters (7), das aus einem anderen Material besteht, umfassen.

13. Hybridstruktur (10) für eine Oberflächenschallwellenvorrichtung nach dem vorhergehenden Anspruch, wobei das zweite Muster (7) aus Siliziumdioxid oder Siliziumnitrid besteht.

14. Verfahren zum Herstellen einer Hybridstruktur (10) für eine Oberflächenschallwellenvorrichtung, **dadurch gekennzeichnet, dass** es die folgenden Schritte umfasst:

   i) Bereitstellen einer Nutzschicht (1) aus piezoelektrischem Material und eines Trägersubstrats (5) mit einem geringeren Wärmeausdehnungskoeffizienten als dem der Nutzschicht (1);
   ii) Lokales Ätzen einer Vorderseite der Nutzschicht (1) oder des Trägersubstrats (5) nach periodischen Mustern, wodurch eine Gruppe von geätzten Mustern und ungeätzten Mustern eines ersten Materials gebildet wird;
   iii) Aufbringen auf die gravierten Muster einer zusätzlichen Schicht aus einem sich vom ersten Material unterscheidenden zweiten Material; wobei die ungeätzten periodischen Muster und die zusätzliche Schicht eine Zwischenschicht (4) bilden;
   iv) Zusammenfügen der Nutzschicht (1) und des Trägersubstrats (5) derart, dass die Zwischenschicht (4) zwischen der Nutzschicht (1) und dem Trägersubstrat (5) angeordnet ist.

15. Verfahren zum Herstellen einer Hybridstruktur (10) für eine Oberflächenschallwellenvorrichtung nach dem vorhergehenden Anspruch, wobei die in Schritt i) bereitgestellte Nutzschicht (1) ein Donatorsubstrat aus piezoelektrischem Material ist.

16. Verfahren zum Herstellen einer Hybridstruktur (10) für eine Oberflächenschallwellenvorrichtung nach dem vorhergehenden Anspruch, umfassend einen Schritt v) des Dünnens des Donatorsubstrats auf die für das Herstellen der Schallwellenvorrichtung gewünschte Dicke der Nutzschicht (1).

**Claims**

1. Hybrid structure (10) for a surface acoustic wave device comprising a useful layer (1) of piezoelectric material joined to a support substrate (5) having a coefficient of thermal expansion lower than that of the useful layer (1), and comprising an intermediate layer (4) located between the useful layer (1) and the support substrate (5), **characterized in that** the intermediate layer (4) is a structured layer formed from at least two different materials and has a plurality of periodic patterns (6,7) in the plane of said intermediate layer (4).

2. Hybrid structure (10) for a surface acoustic wave device according to the preceding claim, wherein the periodicity of the patterns (6,7) is selected according to the frequency of the surface acoustic waves of the device.

3. Hybrid structure (10) for a surface acoustic wave device according to either of the preceding claims, wherein the support substrate (5) comprises a material selected from silicon, glass, silica, sapphire, alumina or aluminum nitride.

4. Hybrid structure (10) for a surface acoustic wave device according to any of the preceding claims, wherein the useful layer (1) comprises a piezoelectric material selected from lithium tantalate ($LiTaO_3$), lithium niobate ($LiNbO_3$), quartz or zinc oxide (ZnO).

5. Hybrid structure (10) for a surface acoustic wave device according to any of the preceding claims, wherein the average acoustic impedance of the intermediate layer (4) is equal to the square root of the product of the acoustic impedances of the useful layer (1) and the support substrate (5).

6. Hybrid structure (10) for a surface acoustic wave device according to any of the preceding claims, wherein the thickness of the intermediate layer (4) is greater than the wavelength of the surface acoustic waves of the device.

7. Hybrid structure (10) for a surface acoustic wave device according to any of the preceding claims, wherein at least one lateral dimension of the patterns (6,7) is less than the wavelength of the surface acoustic waves of the device.

8. Hybrid structure (10) for a surface acoustic wave device according to any of the preceding claims, wherein the periodic patterns (6,7) comprise an alternation of a first pattern (6) composed of the material of the useful layer (1) and a second pattern (7) composed of a material of the same type as that of the support substrate (5).

9. Hybrid structure (10) for a surface acoustic wave device according to the preceding claim, wherein the second pattern (7) is composed of polycrystalline silicon and wherein the support substrate (5) is made of silicon.

10. Hybrid structure (10) for a surface acoustic wave device according to any of claims 1 to 4, wherein the thickness of the intermediate layer (4) is equal to or less than the wavelength of the surface acoustic waves of the device.

11. Hybrid structure (10) for a surface acoustic wave device according to the preceding claim, wherein at least one lateral dimension of the patterns (6,7) is less than or equal to the wavelength of the surface acoustic waves of the device.

12. Hybrid structure (10) for a surface acoustic wave device according to either of the two preceding claims, wherein the periodic patterns (6,7) comprise an alternation of a first pattern (6) composed of the material of the useful layer (1) or the material of the support substrate and a second pattern (7) composed of another material.

13. Hybrid structure (10) for a surface acoustic wave device according to the preceding claim, wherein the second pattern (7) is composed of silicon dioxide or silicon nitride.

14. Method for producing a hybrid structure (10) for a surface acoustic wave device, **characterized in that** it comprises the following steps:

    i) providing a useful layer (1) of piezoelectric material and a support substrate (5) having a coefficient of thermal expansion lower than that of the useful layer (1);

ii) locally etching, according to periodic patterns, a front face of the useful layer (1) or of the support substrate (5), forming a set of etched patterns and non-etched patterns of a first material;

iii) depositing on the etched patterns an additional layer of a second material different from the first material; the non-etched periodic patterns and the additional layer forming an intermediate layer (4);

iv) joining the useful layer (1) and the support substrate (5) so that the intermediate layer (4) is arranged between the useful layer (1) and the support substrate (5).

15. Method for producing a hybrid structure (10) for a surface acoustic wave device according to the preceding claim, wherein the useful layer (1) provided in step i) is a piezoelectric material donor substrate.

16. Method for producing a hybrid structure (10) for a surface acoustic wave device according to the preceding claim, comprising a step v) of thinning the donor substrate to the desired thickness of the useful layer (1) in order to produce the acoustic wave device.

FIG.1

FIG.2

FIG.3a

FIG.3b

FIG.4a

FIG.4b

FIG.4c

FIG.4d

FIG.5a

FIG.5b

FIG.5c

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20120086312 A1
- WO 2005036150 A
- EP 1158671 A
- EP 2658122 A

**Littérature non-brevet citée dans la description**

- **DE K.HASHIMOTO ; M.KADOTA et al.** Recent development of temperature compensated SAW devices. *IEEE Ultrason. Symp.,* 2011, 79-86
- **B.P.ABBOTT et al.** Characterization of bonded wafer for RF filters with reduced TCF. *Proc 2005 IEEE International Ultrasonics Symposium,* 19 Septembre 2005, 926-929